# EUROPÄISCHE PATENTSCHRIFT

(11) **EP 2 018 676 B1**
(45) Veröffentlichungstag und Bekanntmachung des Hinweises auf die Patenterteilung: **12.05.2010**
(21) Anmeldenummer: 07724995.1
(22) Anmeldetag: 08.05.2007
(51) Int. Cl.: H01L 51/42, H01L 21/302, B05D 7/00

(54) **VERFAHREN ZUR HERSTELLUNG EINES MEHRSCHICHTGEBILDES**
METHOD FOR PRODUCTION OF A MULTI-LAYERED OBJECT
PROCÉDÉ DE PRODUCTION D'UN ÉLÉMENT MULTICOUCHE

(30) Priorität: 09.05.2006 DE 102006021410
(43) Veröffentlichungstag der Anmeldung: 28.01.2009
(73) Patentinhaber: Leonhard Kurz Stiftung & Co. KG, 90763 Fürth (DE); Konarka Technologies, Inc., Lowell, MA 01852 (US)
(72) Erfinder: SCHINDLER, Ulrich, 90762 Fürth (DE); BRABEC, Christoph, A-4040 Linz (AT)
(74) Vertreter: Pöhlau, Claus
(86) Internationale Anmeldenummer: PCT/EP2007/004072
(87) Internationale Veröffentlichungsnummer: WO 2007/128575

(56) Entgegenhaltungen:
- WO-A-2005/064705
- DE-A1- 10 306 357
- DE-T- 10 392 830

## Beschreibung

Die Erfindung betrifft ein Verfahren zur Herstellung eines Mehrschichtgebildes, bestehend aus Schichtmedien, die unterschiedliche Oberflächenspannungen besitzen.

Aufgrund der unterschiedlichen Oberflächenspannungen und Oberflächenenergien der Schichtmedien eines Mehrschichtgebildes kann die Applikation der Schichtmedien, bei denen es sich um Lacke, Lösungen usw. handeln kann, problematisch sein. Bei diesen Problemen handelt es sich um Benetzungsprobleme, wenn die Schichtmedien des Mehrschichtgebildes voneinander wesentlich verschiedene Oberflächenspannungen bzw. Oberflächenenergien besitzen. Ein Mehrschichtgebilde aus homogenen Schichten, die die gewünschten Eigenschaften besitzen, sind dann bislang nur unter großen Schwierigkeiten herstellbar. Bei diesen Eigenschaften kann es sich um physikalische Eigenschaften wie elektrische oder elektronische Eigenschaften handeln.

Aus der DE 103 06 357 A1 ist ein Verfahren zur Herstellung einer Mehrschichtbeschichtung, z.B. einer Mehrschichtlackierung, bekannt, bei dem auf eine erste Beschichtung ein nachfolgender Beschichtungsstoff aufgebracht und gehärtet wird. Dabei wird die erste Beschichtung derartig ausgewählt und/oder modifiziert und/oder der nachfolgende Beschichtungsstoff derartig ausgewählt, dass der Quotient aus der Oberflächenenergie der zweiten Beschichtung und der Oberflächenenergie der ersten Beschichtung kleiner oder gleich 1 ist.

Dieses bekannte Verfahren ist insbesondere für die Kfz-Serienlackierung vorgesehen, das von den Herstellungsbedingungen, der Umgebungstemperatur und der Luftfeuchtigkeit weitgehend unabhängig und das auch unter extremen Bedingungen anwendbar ist. Die erste Beschichtung kann dort beispielsweise mittels eines Primers modifiziert werden.

Aus der DE 103 92 830 T5 sind mehrschichtig ausgebildete Solarzellen bekannt, die zwischen zwei Elektroden, wie einer Basiselektrode und einer transparenten Elektrode, eine Aktivschicht aufweisen. Die Aktivschicht weist ein erstes und ein zweites Ladungstransfermaterial auf. Das erste Ladungstransfermaterial kann ein leitfähiges Polymer sein. Das zweite Ladungstransfermaterial kann eine organisches Material, wie z.B. ein konjugiertes Polymer, sein.

Der Erfindung liegt die Aufgabe zugrunde, ein Verfahren der eingangs genannten Art zu schaffen, bei dem es problemlos möglich ist, Schichtmedien mit unterschiedlichen Oberflächenspannungen und Oberflächenenergien homogen aufeinander anzuordnen, um ein gewünschtes Mehrschichtgebilde zu realisieren.

Diese Aufgabe wird erfindungsgemäß durch die Merkmale des Anspruches 1 d.h. dadurch gelöst, dass auf einen Träger, der von einer flexiblen Folie gebildet ist, eine erste Schicht aus einem flüssigen ersten Medium mit einer ersten Oberflächenspannung und auf der ersten Schicht nach deren Trocknung eine zweite Schicht aus einem flüssigen zweiten Medium mit einer zweiten Oberflächenspannung aufgebracht wird, die größer ist als die erste Oberflächenspannung, und dass vor dem Aufbringen der zweiten Schicht auf die getrocknete erste Schicht eine Spreit-Schicht aufgebracht wird, wobei die Spreit-Schicht eine Metalldünnschicht oder eine Metall-Bekeimung ist oder eine Kapillarität besitzt.

Bei der ersten und der zweiten Schicht des Mehrschichtgebildes kann es sich auch um mehr als zwei Schichten handeln.

In der nachfolgenden Tabelle 1 sind Oberflächenspannungen von beispielhaft angegebenen Lösungen SC (= Semiconductor) und PEDOT/PSS angegeben, wobei die Bestimmung der Oberflächenspannungen mittels des "Dynamic Contact Angle a. Tension-Meter DCAT21" der Firma DATA PHYSICS gemessen worden ist.

**Tabelle 1:**

| Lösung | Oberflächenspannung (mN/m) |
|---|---|
| SC | 31,682 |
| PEDOT/PSS | 45,786 |

In der nachfolgenden Tabelle 2 sind die Oberflächenenergien von mit SC und PEDOT/PSS beschichtetem PET angegeben, wobei die Bestimmung der Oberflächenenergien mittels der "Optical Contact Angle Measurement Unit OCA 20" der Firma DATA PHYSICS bestimmt worden sind.

**Tabelle 2:**

| Substrat (fester Zustand) | Oberflächenenergie (gesamt) (mN/m) |
|---|---|
| SC beschichtete Folie | 26,24 |
| PEDOT/PSS beschichtete Folie | 48,16 |

Wie aus Tabelle 2 wie ersichtlich ist, liegt die Oberflächenenergie von mit SCbeschichtetem PET bei größenordnungsmäßig 26 mN/m und die Oberflächenenergie von mit PEDOT/PSS beschichtetem PET bei größenordnungsmäßig 48 mN/m. Die entsprechenden Flüssigkeiten besitzen eine Oberflächenspannung von ca. 32 mN/m für SC und von ca. 46 mN/m für PEDOT/PSS. Soll nun beispielsweise eine mit PEDOT/PSS beschichtete PET-Folie mit SC beschichtet werden, so ergibt sich ohne Weiteres ein Spreiten des flüssigen SC-Mediums, d.h. eine gute Benetzung des SC auf dem PEDOT/PSS. Soll jedoch beispielsweise eine mit SC beschichtete PET-Folie mit flüssigem PEDOT/PSS beschichtet werden, so erfolgt infolge der Tatsache, dass die Oberflächenspannung des flüssigen PEDOT/PSS größer ist als die Oberflächenenergie des getrockneten SC, kein Spreiten des PEDOT/PSS auf dem SC, d.h. nur eine ungenügende Benetzung des PEDOT/PSS auf dem getrockneten SC. Um jedoch auch hier eine gute Benetzung zu erzielen, wird erfindungsgemäß auf die getrocknete SC-Schicht eine Spreitschicht aufgebracht. Bei der Spreitschicht kann es sich um eine Metalldünnschicht handeln. Desgleichen ist es möglich, dass die Spreitschicht eine Metall-Bekeimung ist, die auf der getrockneten ersten Schicht vorgesehen wird, deren Oberflächenenergie kleiner ist als die Oberflächenspannung des flüssigen, auf die getrocknete erste Schicht aufzubringenden zweiten Mediums.

Die Spreitschicht kann auch eine Kapillarität besitzen.

Die Metalldünnschicht kann durch Vakuumbedampfen, durch Kathodenzerstäubung und dergleichen hergestellt werden. Eine die Spreitschicht bildende -Bekeimung kann in einem an sich bekannten galvanischen Verfahren hergestellt werden.

Auf den von einer flexiblen Folie gebildeten Träger kann vor dem Aufbringen der erste Schicht mindestens eine Vorschicht aufgebracht werden. Bei dieser mindestens einen Vorschicht kann es sich um eine elektrisch leitende Schicht handeln, die beispielsweise eine Elektrode eines elektrischen Bauteiles wie einer Solarzelle bildet.

Die erste und die zweite Schicht können aus organischen Halbleitermedien bestehen, wie sie oben beispielhaft als SC und PEDOT/PSS erwähnt worden sind. Bestehen die besagten Schichten aus organischen Halbleitermedien, so sind erfindungsgemäß beispielsweise Polymer-Solarzellen herstellbar.

Weitere Einzelheiten, Merkmale und Vorteile ergeben sich aus der nachfolgenden Beschreibung eines abschnittweise geschnitten und nicht maßstabgetreu gezeichneten Ausführungsbeispieles eines erfindungsgemäß hergestellten Mehrschichtgebildes.

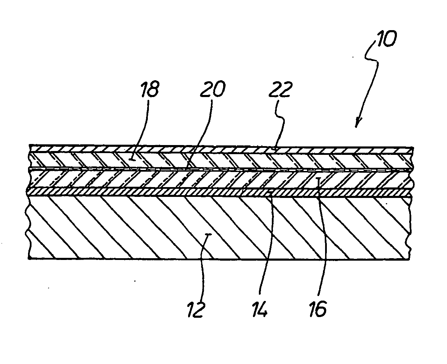

Die Figur zeigt ein Mehrschichtgebilde 10 mit einem von einer flexiblen Folie gebildeten Träger 12, auf dem mindestens eine Vorschicht 14 vorgesehen wird. Auf der mindestens einen Vorschicht 14 wird eine erste Schicht 16 aus einem flüssigen ersten Medium aufgebracht, das eine erste Oberflächenspannung aufweist. Auf der ersten Schicht 16 wird nach deren Trocknung eine zweite Schicht 18 aus einem flüssigen zweiten Medium aufgebracht, das eine zweite Oberflächenspannung besitzt.

Die Oberflächenenergie der getrockneten ersten Schicht 16 ist kleiner als die zweite Oberflächenspannung des flüssigen zweiten Mediums für die zweite Schicht 18, so dass vor dem Aufbringen der zweiten Schicht 18 auf der getrockneten ersten Schicht 16 eine Spreitschicht 20 vorgesehen wird. Bei dieser Spreitschicht 20 kann es sich um eine aufgedampfte oder kathodenzerstäubte Metalldünnschicht oder um eine galvanische Bekeimung oder dergleichen handeln. Die Spreitschicht 20 kann eine bestimmte Kapillarität besitzen, um eine zuverlässige Benetzung der getrockneten ersten Schicht 16 mit dem flüssigen Medium für die zweite Schicht 18 zu bewirken. Auf der getrockneten zweiten Schicht 18 kann dann eine dünne Metallschicht 22 vorgesehen werden, die - wie die Vorschicht 14 - eine Elektrode einer Polymer-Solarzelle bilden kann.

## Patentansprüche

1. Verfahren zur Herstellung eines Mehrschichtgebildes (10), bestehend aus Schichtmedien, die unterschiedliche Oberflächenspannungen und Oberflächenenergien besitzen,
**dadurch gekennzeichnet,**
**dass** auf einen Träger (12), der von einer flexiblen Folie gebildet ist, eine erste Schicht (16) aus einem flüssigen ersten Medium mit einer ersten Oberflächenspannung und auf der ersten Schicht (16) nach deren Trocknung eine zweite Schicht (18) aus einem flüssigen zweiten Medium mit einer zweiten Oberflächenspannung aufgebracht wird, die größer ist als die erste Oberflächenspannung, und dass vor dem Aufbringen der zweiten Schicht (18) auf die getrocknete erste Schicht (16) eine Spreit-Schicht (20) aufgebracht wird, wobei die Spreit-Schicht (20) eine Metalldünnschicht oder eine Metall-Bekeimung ist oder eine Kapillarität besitzt.

2. Verfahren nach Anspruch 1,
**dadurch gekennzeichnet,**
**dass** auf dem Träger (12) vor dem Aufbringen der ersten Schicht (16) mindestens eine Vorschicht (14) aufgebracht wird.

3. Verfahren nach Anspruch 1,
**dadurch gekennzeichnet,**
**dass** die erste und die zweite Schicht (16 und 18) aus organischen Halbleitermedien bestehen.

4. Verwendung des Verfahrens nach einem der Ansprüche 1 bis 3 zur Herstellung von Polymer-Solarzellen.

## Claims

1. Method for producing a multilayer structure (10), consisting of layer media having different surface tensions and surface energies, **characterized in that** a first layer (16) of a liquid first medium with a first surface tension is applied onto a support (12) formed by a flexible film and a second layer (18) of a liquid second medium with a second surface tension is applied on the first layer (16) once it is dry, with the second surface tension being greater than the first surface tension, and **in that** a spreading layer (20) is applied onto the dried first layer (16) before the second layer (18) is applied, wherein the spreading layer (20) is a metal thin layer or a metal seed layer or has a capillarity.

2. Method according to Claim 1, **characterized in that** at least one precoat (14) is applied on the support (12) before the first layer (16) is applied.

3. Method according to Claim 1, **characterized in that** the first and the second layers (16 and 18) consist of organic semiconductor media.

4. Use of method according to one of Claims 1 to 3 for producing polymer solar cells.

## Revendications

1. Procédé de fabrication d'un produit multicouche (10) se composant de milieux stratifiés, qui présentent diverses tensions superficielles et diverses énergies superficielles,
**caractérisé en ce**
**qu'**une première couche (16) se composant d'un premier milieu liquide présentant une première tension superficielle est appliquée sur un support (12) formé par une feuille flexible et en ce qu'une deuxième couche (18) se composant d'un second milieu liquide présentant une seconde tension superficielle plus grande que la première tension superficielle est appliquée sur la première couche (16) après le séchage de cette dernière, et en ce qu'une couche de dispersion (20) est appliquée sur la première couche ayant séché (16) avant l'application de la seconde couche (18), la couche de dispersion (20) étant une fine couche métallique ou une couche de nucléation métallique ou possédant une capillarité.

2. Procédé selon la revendication 1,
**caractérisé en ce**
**qu'**au moins une pré-couche (14) est appliquée sur le support (12) avant l'application de la première couche (16).

3. Procédé selon la revendication 1,
**caractérisé en ce**
**que** la première et la seconde couches (16 et 18) se composent de milieux semi-conducteurs organiques.

4. Utilisation du procédé selon l'une quelconque des revendications 1 à 3 servant à la fabrication de cellules solaires polymères.
